# EUROPEAN PATENT APPLICATION

(11) **EP 4 664 199 A1**
(43) Date of publication of application: **17.12.2025**
(21) Application number: 24753312.8
(22) Date of filing: 05.02.2024
(51) Int. Cl.: G03F 7/11, G03F 7/004, G03F 7/20

(54) **RESIST UNDERLAYER FILM FORMING COMPOSITION**

(30) Priority: 09.02.2023 JP 2023018123
(71) Applicant: Nissan Chemical Corporation, Tokyo 103-6119 (JP)
(72) Inventor: KATO Yuki, Toyama-shi, Toyama 939-2792 (JP); OGATA Hiroto, Toyama-shi, Toyama 939-2792 (JP); TAMURA Mamoru, Toyama-shi, Toyama 939-2792 (JP)
(74) Representative: Hoffmann Eitle
(86) International application number: PCT/JP2024/003725
(87) International publication number: WO 2024/166869

(57) **Abstract**

The present invention provides a resist underlayer film forming composition which makes it possible to suppress a deterioration of line width roughness (LWR) during the formation of a resist pattern without causing intermixture with a resist film formed on a resist underlayer film. Provided is a resist underlayer film forming composition comprising: (A) a phenol-based antioxidant which has a carbon number of seven or more and in which at least one of the carbon atoms at the ortho position and the para position of a phenolic hydroxy group on an aryl ring has a hydrogen atom that can be substituted; (B) a crosslinking agent-reactive polymer; (C) a crosslinking agent; (D) a curing catalyst; and (E) a solvent. Also provided are a resist underlayer film which is a cured product of a coating film made of the resist underlayer film forming composition and a method for producing a semiconductor device in which the resist underlayer film forming composition is used.

## Description

### Technical Field

The present invention relates to a composition used in a lithography process for semiconductor production. The present invention also relates to the application of a resist underlayer film from the composition to a method for producing a resist-patterned substrate and to a method for manufacturing a semiconductor device.

### Background Art

In the manufacturing of semiconductor devices, lithographic microprocessing using a resist composition has conventionally been carried out. The microprocessing is a process, in which a thin film of a photoresist composition is formed on a semiconductor substrate, such as a silicon wafer, the formed film is irradiated with an active ray, such as ultraviolet light, through a mask pattern for drawing a device pattern, then the irradiated film is developed, and the substrate is etched while using the thus-obtained photoresist pattern as a protective film, thereby forming fine irregularities corresponding to the pattern on the substrate surface. In recent years, with the increase in integrity of semiconductor devices, practical use of active rays such as EUV light (extreme ultraviolet light, 13.5 nm wavelength) and EB (electron beam) are being studied in the leading-edge microprocessing in addition to the conventionally used i-ray (365 nm wavelength), KrF excimer laser beam (248 nm wavelength), and ArF excimer laser beam (193 nm wavelength). A growing problem along with this trend is that a resist pattern cannot be formed as designed due to influence from, for example, a semiconductor substrate. An approach that is widely studied to solve the above problem is to provide a resist underlayer film between a resist and a semiconductor substrate.

For example, the properties required to resist underlayer films include that the resist underlayer film is not intermixed with a resist film formed thereon (is insoluble in a resist solvent). Moreover, there are demands that a resist pattern should be formed with a good rectangular shape while avoiding deterioration in LWR (line width roughness, variation (roughness)) in line width) at the time of resist pattern formation, and the resist sensitivity should be enhanced (see Patent Literatures 1 to 4).

### Citation List

### Patent Literature

Patent Literature 1: WO 2020/071361
Patent Literature 2: WO 2016/063805
Patent Literature 3: WO 2013/141015
Patent Literature 4: WO 2015/163195

### Summary of Invention

### Technical Problem

An object of the present invention is to provide a novel composition for forming a resist underlayer film having the above required properties, a resist underlayer film obtainable from the resist underlayer film-forming composition, a laminate including the resist underlayer film and a substrate, and a method for manufacturing a semiconductor substrate including the laminate.

### Solution to Problem

Aspects of the present invention include the following:
[1]
   A resist underlayer film-forming composition comprising a phenolic antioxidant (A) having seven or more carbon atoms, and containing an aryl ring having a phenolic hydroxy group, wherein at least one of carbon atoms in ortho or para position relative to a carbon atom carrying the phenolic hydroxy group of the aryl ring has a substitutable hydrogen atom; a crosslinker-reactive polymer (B); a crosslinker (C); a curing catalyst (D); and a solvent (E).
[2]
   The resist underlayer film-forming composition according to [1], wherein the phenolic antioxidant (A) is at least one member selected from the group consisting of antioxidants represented by formulas (I) to (III) below: 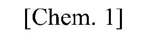 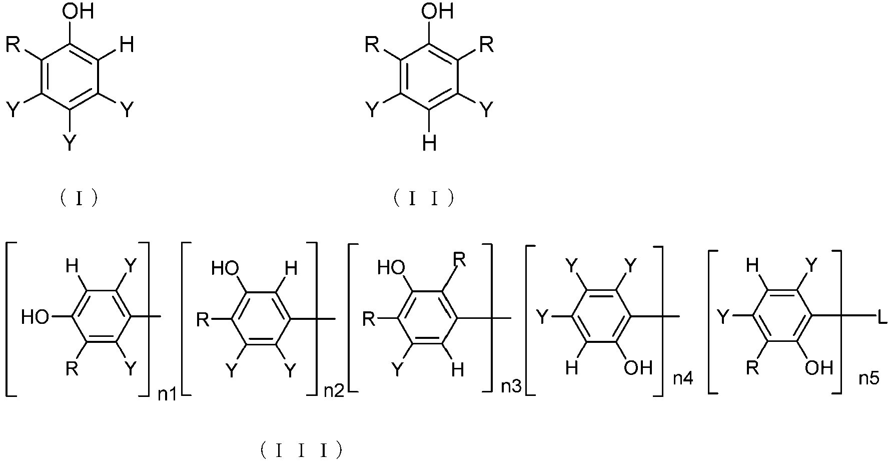 [in formulas (1) to (III),
   R independently at each occurrence denotes an optionally substituted C1-C10 alkyl group or a halogeno group,
   Y independently at each occurrence denotes a hydrogen atom, a hydroxy group, a C1-C10 alkoxy group, an optionally substituted C1-C10 alkyl group, or a halogeno group; when any R and Y adjacent to each other, or any two Ys adjacent to each other are both optionally substituted alkyl groups, the optionally substituted alkyl groups are optionally bonded to each other to form a ring; when one Y is a hydroxy group, the other Y or Ys on the same benzene ring each denote a hydrogen atom, a C1-C10 alkoxy group, an optionally substituted C1-C10 alkyl group, or a halogeno group,
   L denotes a (n1 + n2 + n3 + n4n + n5)-valent linking group that connects the carbon atoms of a (n1 + n2 + n3 + n4 + n5) quantity of benzene rings each constituting a phenol ring; n1, n2, n3, n4, and n5 each indicate an integer of 0 or greater; and the total of n1, n2, n3, n4, and n5 is 2 or greater].
[3]
   The resist underlayer film-forming composition according to [2], wherein formula (I) is the following formula (I-1) or (I-2): 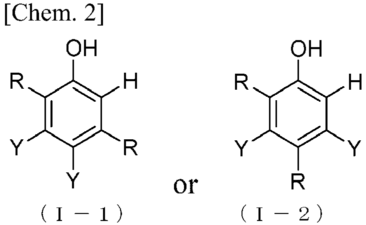 [wherein R and Y in formula (I-1) and formula (I-2) are the same as defined in formula (I)].
[4]
   The resist underlayer film-forming composition according to [1] or [2], wherein the crosslinker-reactive polymer (B) is a cyanuric acid-based polymer, a polyester-based polymer, or an acrylic-based polymer.
[5]
   The resist underlayer film-forming composition according to any one of [1] to [4], wherein the crosslinker (C) is at least one member selected from the group consisting of aminoplast crosslinkers and phenoplast crosslinkers.
[6]
   The resist underlayer film-forming composition according to any one of [1] to [5], wherein the solvent (E) comprises at least one member selected from the group consisting of alkylene glycol monoalkyl ethers and alkylene glycol monoalkyl ether monocarboxylates.
[7]
   A resist underlayer film comprising a cured product of a coating film comprising the resist underlayer film-forming composition according to any one of [1] to [6].
[8]
   The resist underlayer film according to claim 7, which has a contact angle to water of 55° or more.
[9]
   A laminate comprising a substrate and the resist underlayer film according to claim 7 or 8.
[10]
   A method for manufacturing a semiconductor device, comprising:
   forming on a semiconductor substrate a resist underlayer film, which is a cured product of a coating film comprising the resist underlayer film-forming composition according to any one of [1] to [6]; and
   forming a resist film on the resist underlayer film.
[11]
   A method for manufacturing a semiconductor device, comprising:
   forming on a semiconductor substrate a resist underlayer film comprising a cured product of a coating film comprising the resist underlayer film-forming composition according to any one of [1] to [6];
   forming a resist film on the resist underlayer film;
   photoexposing the resist film;
   developing the photoexposed resist film, to form a resist pattern; and
   forming a patterned resist underlayer film by etching the resist underlayer film through the resist pattern.

### Advantageous Effects of Invention

The novel resist underlayer film provided according to the present invention is not intermixed with a resist film formed thereon and allows a resist pattern to be formed with a good rectangular shape while avoiding deterioration in LWR (line width roughness, variation (roughness)) in line width) at the time of resist pattern formation.

### Description of Embodiments

[1] Resist underlayer film-forming composition
(1-1)
   A resist underlayer film-forming composition according to one embodiment of the present invention comprises:
   (A) a phenolic antioxidant having seven or more carbon atoms, and containing an aryl ring having a phenolic hydroxy group, wherein at least one of carbon atoms in ortho or para position relative to a carbon atom carrying the phenolic hydroxy group of the aryl ring has a substitutable hydrogen atom;
   (B) a crosslinker-reactive polymer;
   (C) a crosslinker;
   (D) a curing catalyst; and
   (E) a solvent.
(1-2) Phenolic antioxidants (A)
   (1-2-1)
   The phenolic antioxidant used in the resist underlayer film-forming composition according to one embodiment of the present invention is a phenolic antioxidant having seven or more carbon atoms, and containing an aryl ring having a phenolic hydroxy group, wherein at least one of carbon atoms in ortho or para position relative to a carbon atom carrying the phenolic hydroxy group of the aryl ring has a substitutable hydrogen atom.

Examples of the aryl rings include benzene ring, naphthalene ring, acenaphthylene ring, anthracene ring, and phenanthrene ring; and benzene ring is preferable.

The phenolic hydroxy group is a hydroxy group on a benzene ring that constitutes the entirety or at least part of the aryl ring (for example, any of the benzene rings constituting a naphthalene ring). At least one of the carbon atoms in ortho or para position relative to the carbon atom carrying the phenolic hydroxy group has a substitutable hydrogen atom. Attributable to the presence of the substitutable hydrogen atom, the phenolic antioxidant reacts with a crosslinker, thereby can be incorporated into the resin resulting from the crosslinking. This can reduce the loss of the phenolic antioxidant during a cleaning process in the manufacturing of semiconductor devices, and maintain the effects of the antioxidant.

The number of carbon atoms in the phenolic antioxidant is seven (7) or more, preferably 10 or more, more preferably 11 or more, and still more preferably 14 or more. The number of carbon atoms in the phenolic antioxidant is preferably 50 or less, and more preferably 40 or less. In order to ensure that the phenolic antioxidant will easily migrate during the crosslinking reaction to the surface of the cured film and will exhibit more effectively the antioxidant effect, it is preferable that the number of carbon atoms be larger and the lipophilicity be higher. Although it is not bound by theory, the above configuration probably makes it possible to quench excess active components before unnecessary diffusion of the composition, and enables avoiding the deterioration in LWR [line width roughness, variation (roughness)) in line width] at the time of resist pattern formation.

The amount of the phenolic antioxidant is preferably within the range of 0.1 to 40% by mass, more preferably 1 to 30% by mass, and still more preferably 5 to 20% by mass of the solid content in the resist underlayer film-forming composition according to one embodiment of the present invention.

(1-2-2)
Preferred examples of the phenolic antioxidant (A) include the following formulas (I) to (III):

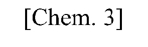

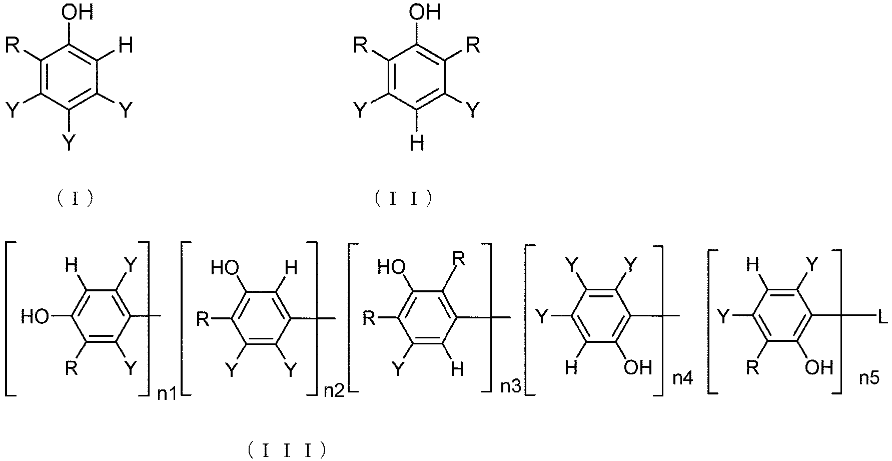

In formulas (1) to (III),
R independently at each occurrence denotes an optionally substituted C1-C10 alkyl group or a halogeno group. R is preferably a C4-C8 tertiary alkyl group, and more preferably a t-butyl group.

Y independently at each occurrence denotes a hydrogen atom, a hydroxy group, a C1-C10 alkoxy group, an optionally substituted C1-C10 alkyl group, or a halogeno group. The optionally substituted C1-C10 alkyl group denoted by Y is preferably a C4-C8 tertiary alkyl group, and more preferably a t-butyl group.

When any R and Y adjacent to each other, or any two Ys adjacent to each other are both optionally substituted alkyl groups, the optionally substituted alkyl groups are optionally bonded to each other to form a ring. When one Y is a hydroxy group, the other Y or Ys on the same benzene ring each denote a hydrogen atom, a C1-C10 alkoxy group, an optionally substituted C1-C10 alkyl group, or a halogeno group.

L denotes a (n1 + n2 + n3 + n4 + n5)-valent linking group that connects the carbon atoms of the (n1 + n2 + n3 + n4 + n5) quantity of benzene rings each constituting a phenol ring; n1, n2, n3, n4, and n5 each indicate an integer of 0 or greater; and the total of n1, n2, n3, n4, and n5 is 2 or greater, and preferably 2 or 3.

L is preferably a divalent or trivalent linking group.

For example, the divalent linking group L may be selected from the group consisting of -O-, -S-, -SO₂-, -CO-, -CONH-, -COO-, -NH-, -(CR¹R²)m¹-, -(Ar)m²-, - CH₂-(Ar)m²-CH₂-, and -(cyclo-R)-. Here, R¹ and R² are the same as or different from each other and each independently denote a hydrogen atom, a C1-C5 hydrocarbon group (for example, a C1-C5 branched or linear alkylene group), or a C6-C30 aryl group; m¹ denotes an integer of 1 to 10; Ar denotes a C6-C30 arylene group; m² denotes an integer of 1 to 3 that is the number of the aromatic rings bonded to one another via a single bond; and cyclo-R denotes a divalent alicyclic hydrocarbon group with a 5-8 membered ring optionally forming a condensed ring with one or two benzene rings or naphthalene rings.

Examples of the trivalent linking groups L include:

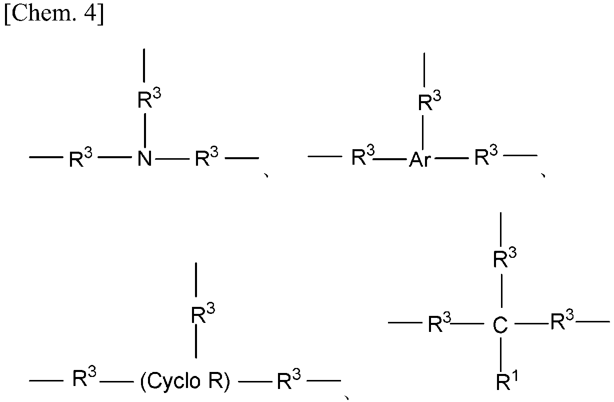

In the above formulas, R³ independently at each occurrence denotes a single bond or a C1-C5 branched or linear alkylene group; Ar denotes a C6-C30 aryltriyl group (a trivalent aromatic group, for example, a triazine group); cyclo-R denotes a trivalent alicyclic hydrocarbon group with a 5-8 membered ring optionally forming a condensed ring with one or two benzene rings or naphthalene rings; and R¹ denotes a hydrogen atom, a C1-C5 hydrocarbon group, or a C6-C30 aryl group.

Formula (I) is more preferably the following formula (I-1) or (I-2): 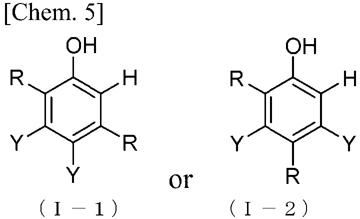 [wherein R and Y in formula (I-1) and formula (I-2) are the same as defined in formula (I)].

Formula (III) is more preferably the following formula (III-1): 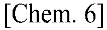 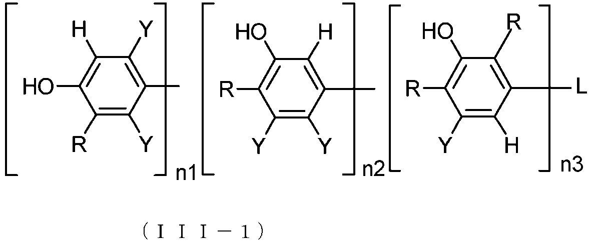 [wherein R and Y in formula (III-I) are the same as defined in formula (III); L denotes a (n1 + n2 + n3)-valent linking group that connects the carbon atoms of the (n1 + n2 + n3) quantity of benzene rings each constituting a phenol ring; n1, n2, and n3 each indicate an integer of 0 or greater; and the total of n1, n2, and n3 is 2 or greater, and preferably 2 or 3].

(1-2-2)
More specific examples of the phenolic antioxidants in the present invention include the following phenolic antioxidants, which are available from, for example, ADEKA CORPORATION, Tokyo Chemical Industry Co., Ltd., and Kawaguchi Chemical Industry Co., Ltd.

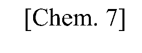

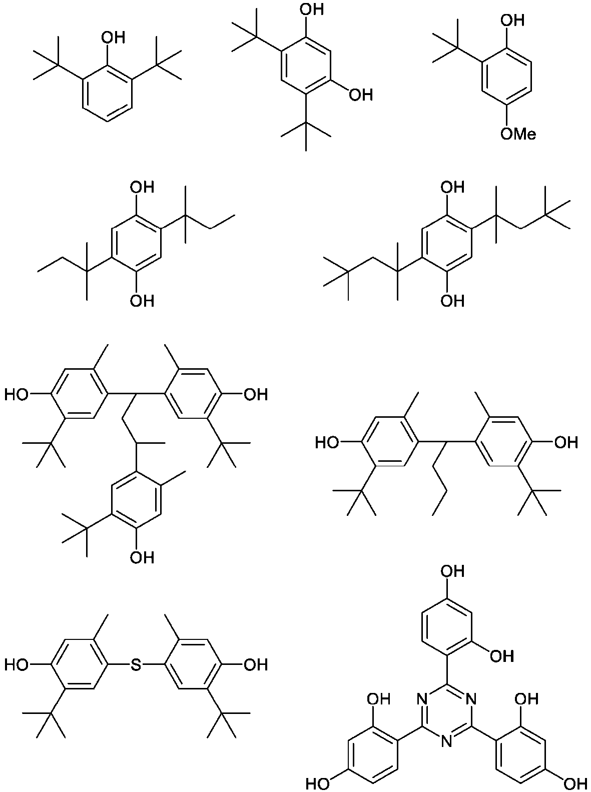

(1-3) Crosslinker-reactive polymer (B)
(1-3-1)
The crosslinker-reactive polymer used in the resist underlayer film-forming composition according to one embodiment of the present invention is a polymer that can undergo a crosslinking reaction with a crosslinker by the action of an acid. **In** the present embodiment, the acid is provided by a curing catalyst. The polymer may be an uncrosslinked polymer or a partially crosslinked polymer and, by reacting with a crosslinker, can form a film that is not dissolved with a photoresist solvent.

At least part of the repeating structural units of the crosslinker-reactive polymer in the present embodiment contain a crosslinking site that has a crosslinkable functional group for undergoing a crosslinking reaction with a crosslinker. When, for example, the crosslinker is an aminoplast crosslinker or phenoplast crosslinker that is considered to generate cationic active species in the presence of an acid, the polymer contains structural units that have a crosslinkable functional group reactive with cationic active species, such as a hydroxy group, an unsaturated hydrocarbon group (for example, an allyl group), or an aromatic group. Of those mentioned above, hydroxy groups are preferable as the crosslinkable functional groups.

The crosslinker-reactive polymers that may be used in the present embodiment include curable resins, such as epoxy resins, novolac resins (including phenolformaldehyde resins, aniline-formaldehyde resins, and the like), and unsaturated polyester resins, as well as polymers having a specific polymer backbone and a crosslinkable functional group capable of reacting with a specific crosslinker.

Preferred examples of such specific polymer backbones include cyanuric acid-based polymers, polyester-based polymers, and acrylic-based polymers (such as polyacrylic acids, polyacrylic acid esters, polymethacrylic acids, and polymethacrylic acid esters).

The polymer backbone preferably contains a heterocyclic structure. Examples of the heterocyclic rings include furan, thiophene, pyrrole, imidazole, pyran, pyridine, pyrimidine, pyrazine, pyrrolidine, piperidine, piperazine, morpholine, indole, purine, quinoline, isoquinoline, quinuclidine, chromene, thianthrene, phenothiazine, phenoxazine, xanthene, acridine, phenazine, carbazole, triazinone, triazinedione, and triazinetrione.

The heterocyclic structure is preferably a triazinone, triazinedione, or triazinetrione structure, and is most preferably a triazinetrione structure.

The content of the crosslinker-reactive polymer is not particularly limited but is preferably within the range of 40 to 99% by mass, and more preferably 50 to 99% by mass of the solid content in the resist underlayer film-forming composition according to one embodiment of the present invention.

(1-3-2)
Specific examples of the crosslinker-reactive polymer include the following polymers: 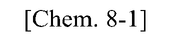 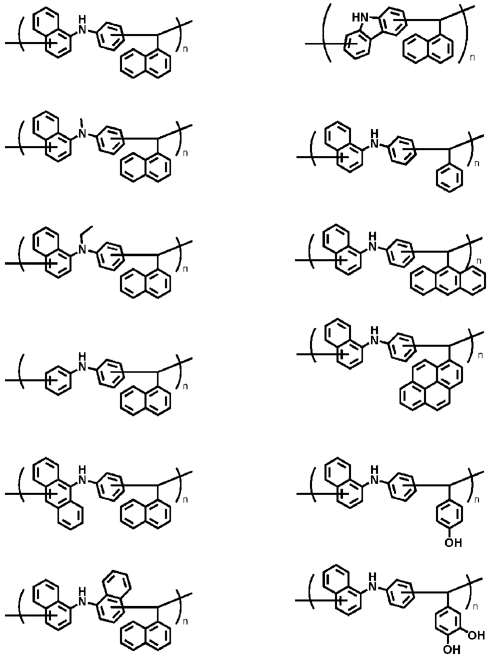 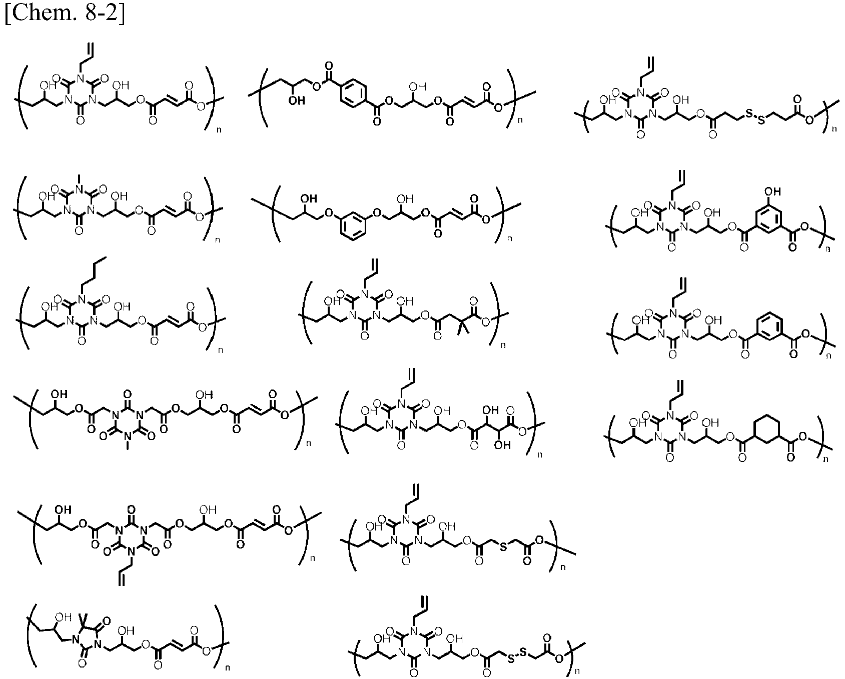 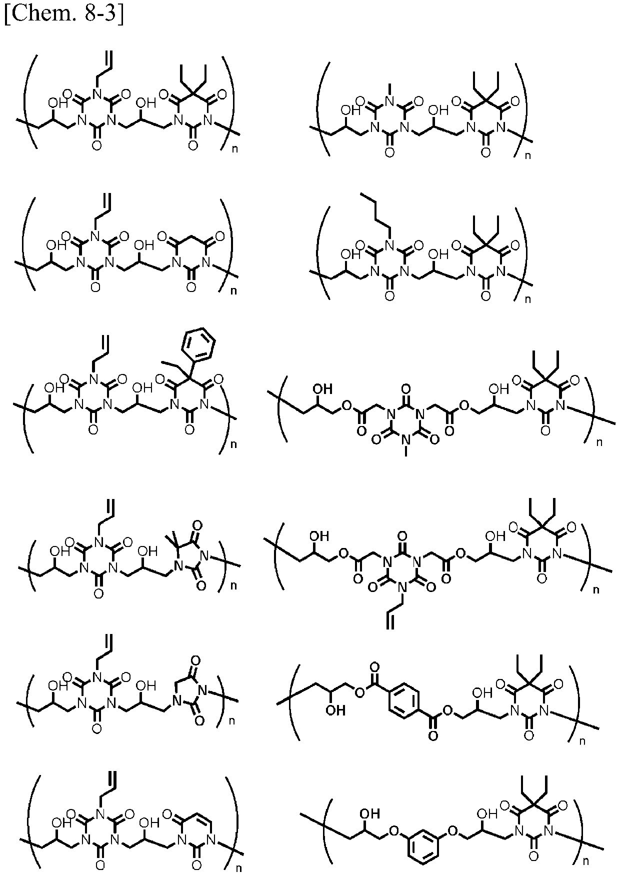 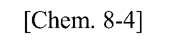 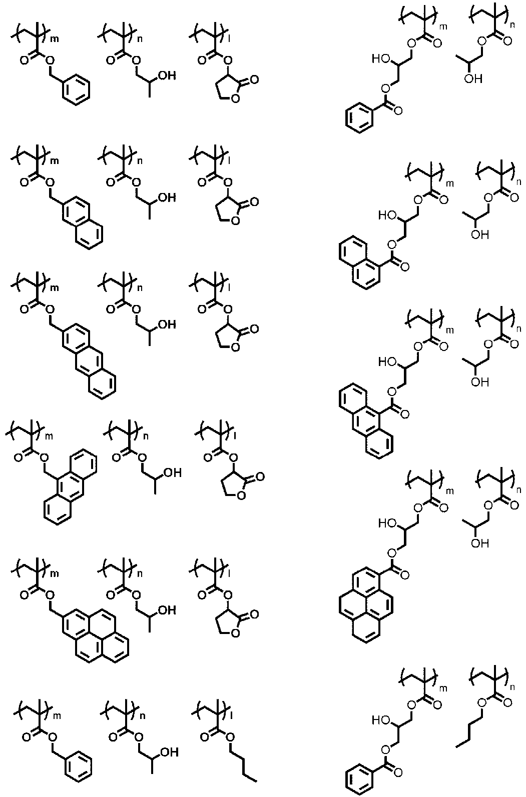 (wherein m, n, 1, and numbers indicate the molar ratio or the number (any number) of repeating units. Usually, m, n, and 1 are each independently an integer of 5 to 100).

(1-3-3)
A preferred crosslinker-reactive polymer for use in the resist underlayer film-forming composition according to one embodiment of the present invention is a reaction product (an epoxy resin) between a compound containing two epoxy groups and a compound selected from the group consisting of dicarboxylic acid-containing compounds, acid dianhydrides, compounds containing two imino groups, and compounds having two hydroxy groups (WO 2022/039246). The ring-opening of the epoxy groups results in hydroxy groups that are crosslinkable functional groups.

Examples of the compound containing two epoxy groups include the following compounds (a) to (h) and (v) to (x). The compounds containing two epoxy groups may be compounds containing two glycidyl groups.

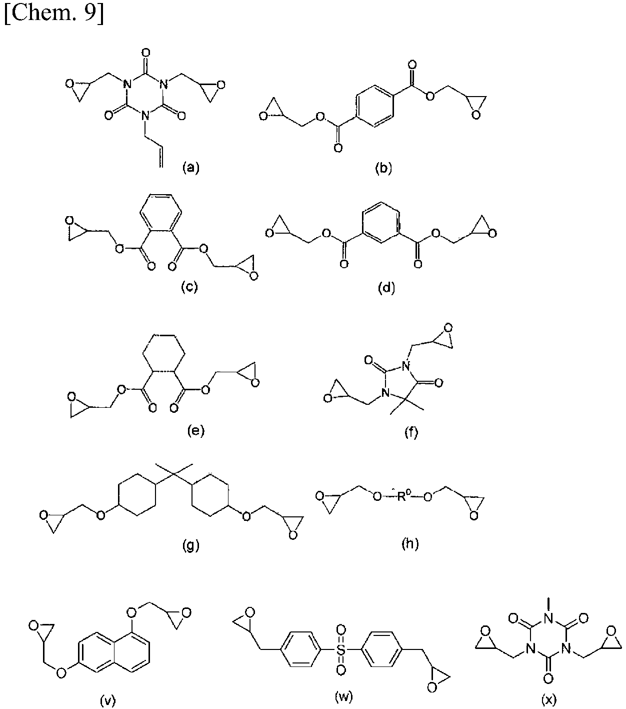

The above compounds (a) and (x) give cyanuric acid-based polymers.

In formula (h), R⁰ denotes a C2-C6 alkylene group.

Examples of the compounds selected from the group consisting of dicarboxylic acid-containing compounds, acid dianhydrides, compounds containing two imino groups, and compounds having two hydroxy groups include the following compounds (i) to (u). The hydroxy group may be a phenolic hydroxy group or a non-phenolic hydroxy group.

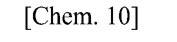

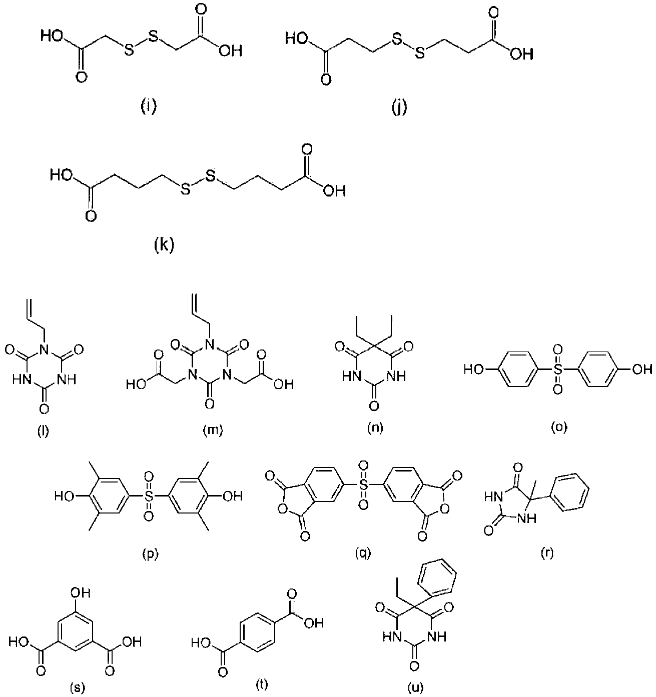

The above compounds (l) and (m) give cyanuric acid-based polymers.

(1-3-4)
For example, the polymer used in the resist underlayer film-forming composition according to one embodiment of the present invention may be a polymer of formula (11) below that is described in WO 2009/096340.

The polymer has a repeating unit structure represented by: 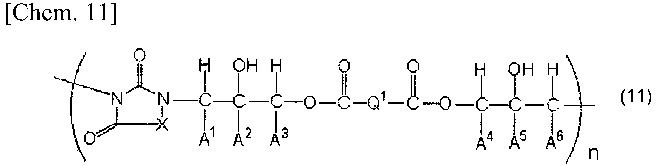 [in formula (11), X is represented by formula (12), formula (13), or formula (14) below: 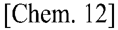 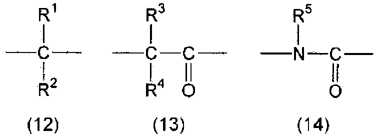 [in formulas (12), (13), and (14),
R¹ to R⁵ each independently denote a hydrogen atom, a C1-C6 alkyl group, a C3-C6 alkenyl group, a benzyl group, or a phenyl group, wherein the phenyl group is optionally substituted with at least one group selected from the group consisting of C1-C6 alkyl groups, halogen atoms, C1-C6 alkoxy groups, nitro groups, cyano groups, and C1-C6 alkylthio groups; and the pair of R¹ and R², and the pair of R³ and R⁴ may be each bonded to each other to form a C3-C6 ring,
A¹ to A⁶ each independently denote a hydrogen atom, a methyl group, or an ethyl group,
Q¹ denotes a divalent group containing a disulfide bond, and
n is the number of the repeating unit structures and may be an integer of 5 to 100]. Further information regarding this polymer described in WO 2009/096340 is incorporated herein by reference.

(1-3-5)
For example, the polymer used in the resist underlayer film-forming composition according to one embodiment of the present invention may be a polymer having a structural unit of formula (23) below that is described in WO 2020/071361. 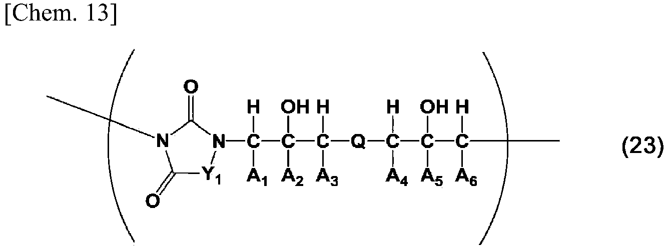 [In formula (23), A₁, A₂, A₃, A₄, A₅, and A₆ each independently denote a hydrogen atom, a methyl group, or an ethyl group; Y₁ is represented by formula (24), formula (25), formula (26), or formula (27) below: 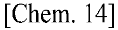 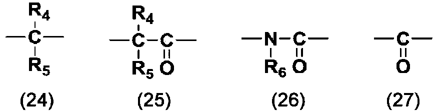 [in formulas (24) to (27), R₄ and R₅ each independently denote a hydrogen atom, a C1-C6 alkyl group, a C3-C6 alkenyl group, a benzyl group, or a phenyl group, wherein the phenyl group is optionally substituted with at least one group selected from the group consisting of C1-C6 alkyl groups, halogen atoms, C1-C6 alkoxy groups, nitro groups, cyano groups, hydroxy groups, and C1-C6 alkylthio groups; R₄ and R₅ may be bonded to each other to form a C3-C6 ring; and R₆ denotes a C1-C6 alkyl group, a C3-C6 alkenyl group, a benzyl group, or a phenyl group, wherein the phenyl group is optionally substituted with at least one group selected from the group consisting of C1-C6 alkyl groups, halogen atoms, C1-C6 alkoxy groups, nitro group, cyano group, hydroxy group, and C1-C6 alkylthio groups; and Q is represented by formula (28) or formula (29): 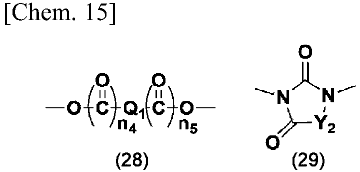 [in formulas (28) and (29), Q₁ denotes a C1-C10 alkylene group, a phenylene group, a naphthylene group, or an anthrylene group, wherein the phenylene group, the naphthylene group, and the anthrylene group are each optionally substituted with at least one group selected from the group consisting of C1-C6 alkyl groups, halogen atoms, C1-C6 alkoxy groups, nitro group, cyano group, hydroxy group, and C1-C6 alkylthio groups; n₄ and n₅ each independently indicate a number of 0 or 1; and Y₂ is represented by formula (24), formula (25), or formula (27).]

Further information regarding this polymer described in WO 2020/071361 is incorporated herein by reference.

(1-3-6)
For example, the acrylic acid-based polymer used in the resist underlayer film-forming composition according to one embodiment of the present invention may be a polymer described in WO 2012/017790 that contains a structural unit represented by the following formula (1) and a structural unit with a crosslinking site represented by the following formula (2).

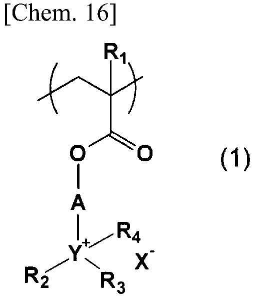

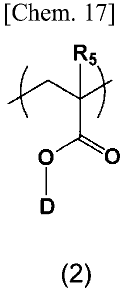

In formula (1), R₁ denotes a hydrogen atom or a methyl group; A denotes a C1-C13 alkylene group or a phenylene group; Y denotes a nitrogen atom or a phosphorus atom; R₂, R₃, and R₄ each independently denote a hydrogen atom, a C1-C13 alkyl group, or a phenyl group; and X⁻ denotes an anion selected from the group consisting of C1-C13 alkylsulfonate anions, C1-C13 alkylsulfate anions, chloride anion, bromide anion, C1-C13 fluoroalkylsulfonate anions, boron tetrafluoride anion, phosphorus hexafluoride anion, and C1-C13 alkylcarboxylate anions.

In formula (2), R₅ denotes a hydrogen atom or a methyl group; and D denotes a linear, branched, or cyclic C1-C13 hydrocarbon group, wherein the hydrocarbon group has at least one hydroxy group as a substituent.

Further information regarding this polymer described in WO 2012/017790 is incorporated herein by reference.

(1-3-7)
The acrylic acid-based polymer used in the resist underlayer film-forming composition according to one embodiment of the present invention may be a polymer described in JP 2004-309561 A that has structural units represented by the following (A), (B-1), and (C-1): 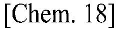 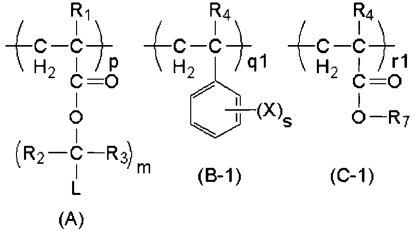 (wherein X denotes a hydrogen atom, a C1-C5 alkyl group, a halogen atom, a hydroxy group, a C1-C5 alkoxy group, an acetyl group, or a cyano group; R₇ denotes a C2-C6 alkyl group having at least one hydroxy group, a hydrogen atom, or a glycidyl group; s denotes a number from 1 to 5; q1 and r1 each denote the number of the structural units present in the polymer and each indicate a number from 1 to 3000; R₁ denotes a hydrogen atom, a methyl group, an ethyl group, or a chlorine atom; R₂ and R₃ each denote a hydrogen atom, a methyl group, or an ethyl group; R₄ independently at each occurrence denotes a hydrogen atom, a methyl group, an ethyl group, or a chlorine atom; L denotes a polycyclic alicyclic structure; m is a number of 0 or 1; and p denotes the number of the structural units present in the polymer and indicates a number from 1 to 3,000).

Alternatively, the polymer may be one having structural units represented by the following (A), (B-2), and (C-1): 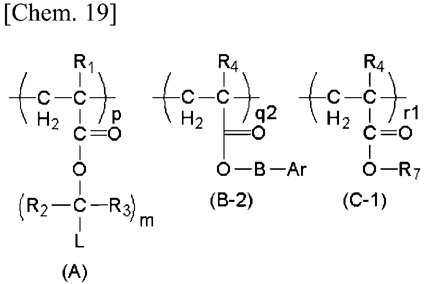 (wherein B denotes a direct bond or a linking group including at least one linking group selected from -CH₂- and -O-; q2 denotes the number of the structural units present in the polymer and indicates a number from 1 to 3,000; Ar denotes a benzene ring, a naphthalene ring, or an anthracene ring each optionally substituted with a C1-C5 alkyl group, a halogen atom, a hydroxy group, a C1-C5 alkoxy group, an acetyl group, or a cyano group; and R₁, R₂, R₃, R₄, R₇, m, p, and r1 are the same as defined hereinabove).

(1-3-8)
An end of the polymer chain used in the resist underlayer film-forming composition according to one embodiment of the present invention may be blocked with a compound containing an aliphatic ring. The aliphatic ring may be substituted with a substituent, or the carbon-carbon bonds of the aliphatic ring may be interrupted by a heteroatom.

The aliphatic ring is preferably a C3-C10 monocyclic or polycyclic aliphatic ring, and the polycyclic aliphatic ring is preferably a bicyclic or tricyclic ring.

It is also preferable that the aliphatic ring have at least one unsaturated bond.

Specific examples of such aliphatic rings include polymer ends derived from a carboxyl-containing aliphatic ring compound, such as those illustrated below. Such compounds may form a new polymer end by bonding to a polymer's end that has such a functional group as a hydroxy group or an amino group, for example, that is capable of forming a chemical bond with the carboxyl group .

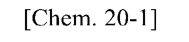

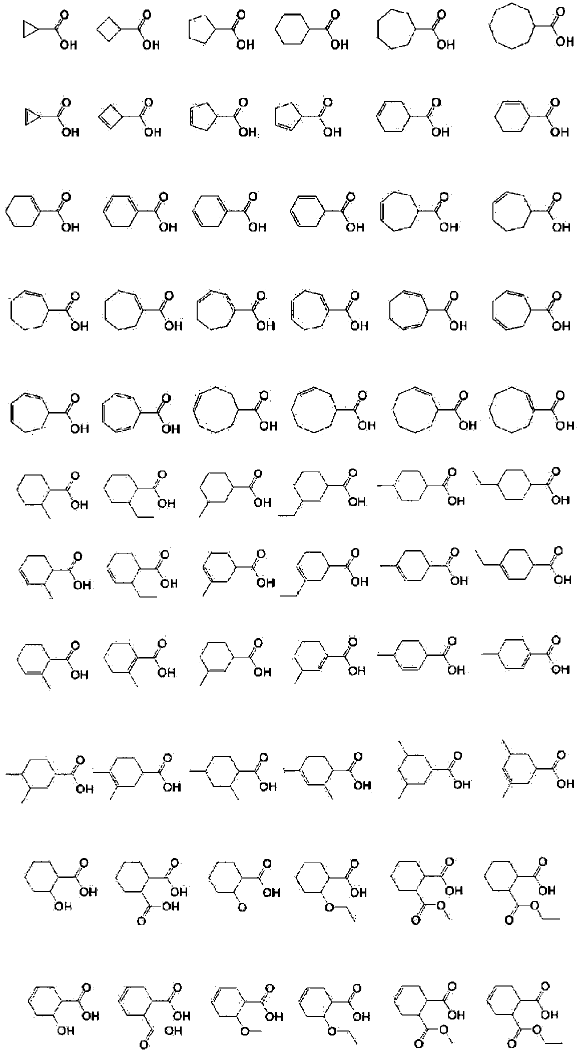

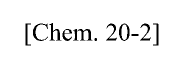

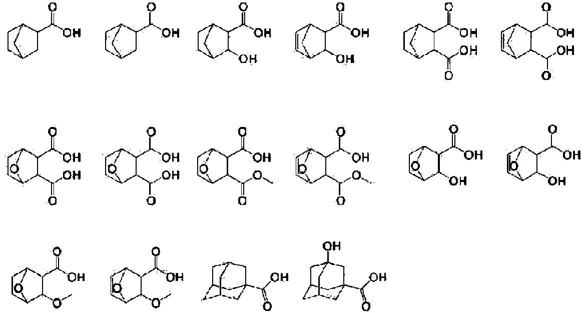

Further details of the compounds that contain an aliphatic ring optionally interrupted by a heteroatom at any carbon-carbon bond and optionally substituted with a substituent are described in WO 2020/226141, which is incorporated herein by reference.

(1-3-9)
An end of the polymer chain used in the resist underlayer film-forming composition according to one embodiment of the present invention may have a structure of the following formula (31) or (32) that is described in WO 2020/071361. By virtue of the polymer being terminated with such a structure, the deterioration in LWR (line width roughness, variation (roughness)) in line width) at the time of resist pattern formation can be further reduced. 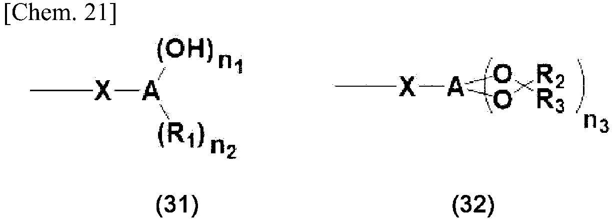 [In formulas (31) and (32), X is a divalent organic group; A is a C6-C40 aryl group; R₁ is a halogen atom, a C1-C10 alkyl group, or a C1-C10 alkoxy group; R₂ and R₃ are each independently a hydrogen atom, a halogen atom, an optionally substituted C1-C10 alkyl group, or an optionally substituted C6-C40 aryl group; n1 and n3 are each independently an integer of 1 to 12; and n2 is an integer of 0 to 11.]

(1-3-9-1)
For example, the compounds having a partial structure represented by formula (31) are represented by the following formula (1-1). Such compounds can form a new polymer end by bonding to a polymer's end that has such a functional group as, for example, a hydroxy group or an amino group, that is capable of forming a chemical bond with the carboxyl group . 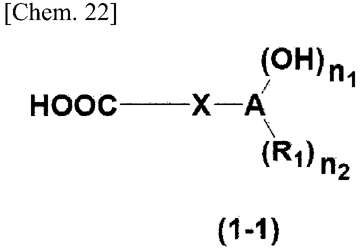 [In formula (1-1), X is a divalent organic group; A is a C6-C40 aryl group; R₁ is a halogen atom, a C1-C40 alkyl group, or a C1-C40 alkoxy group; n1 is an integer of 1 to 12; and n2 is an integer of 0 to 11.]

Specific examples of the compound represented by formula (1-1) include the following:

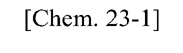

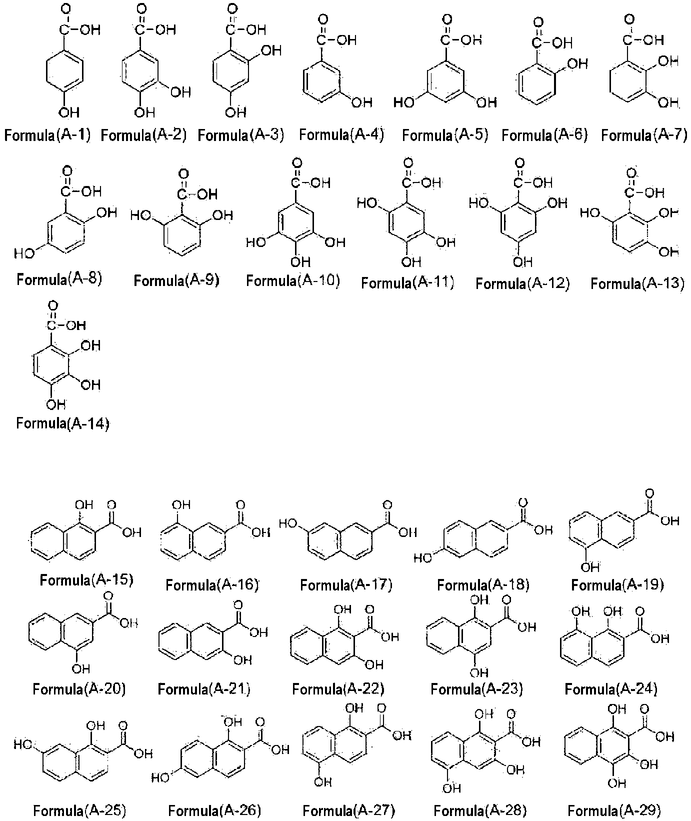

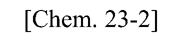

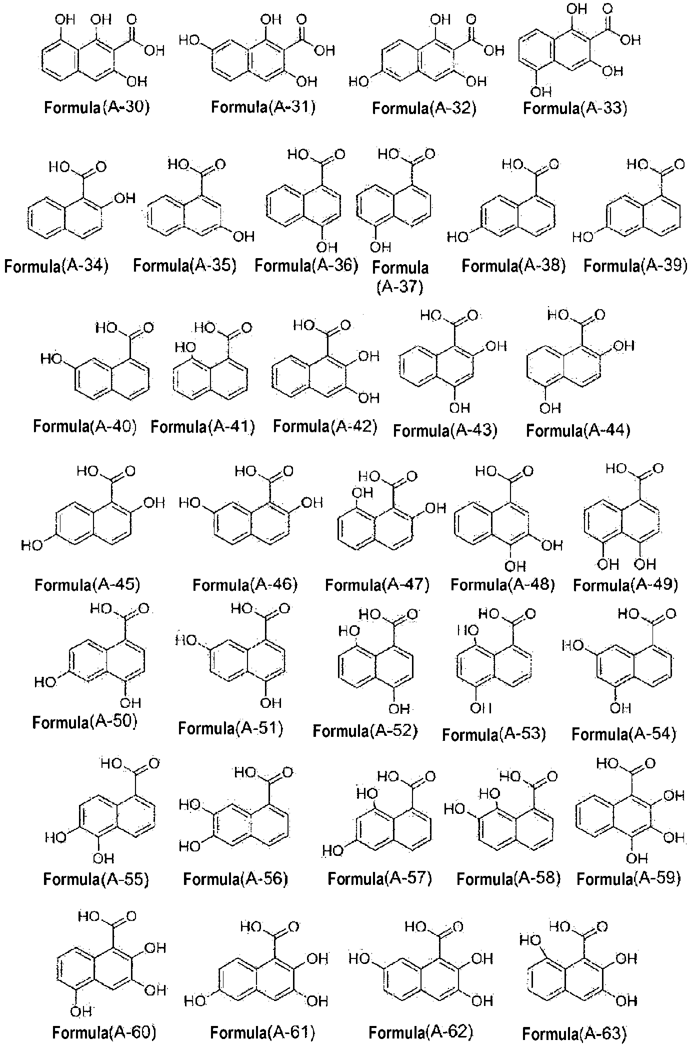

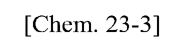

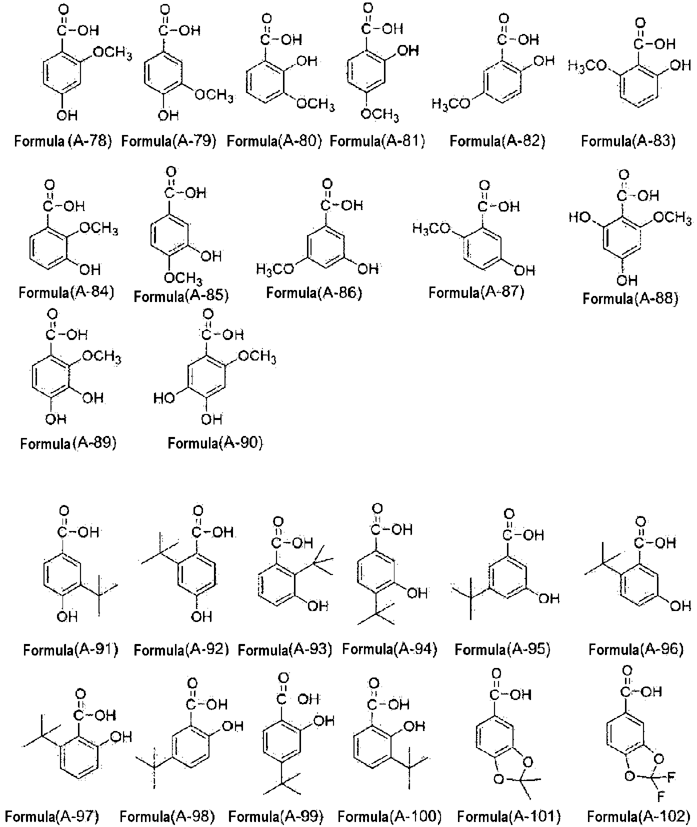

(1-3-9-2)
For example, the compounds having a partial structure represented by formula (32) are represented by the following formula (2-1). Such compounds can form a new polymer end by bonding to a polymer end that has such a functional group as, for example, a hydroxy group or an amino group, that is capable of forming a chemical bond with the carboxyl group . 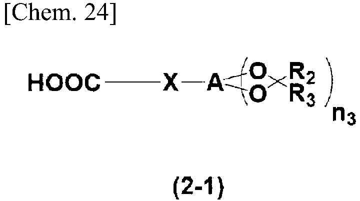 [In formula (2-1), X is a divalent organic group; A is a C6-C40 aryl group; R₂ and R₃ are each independently a hydrogen atom, an optionally substituted C1-C10 alkyl group, an optionally substituted C6-C40 aryl group, or a halogen atom; and n₃ is an integer of 1 to 12.]

Specific examples of the compounds represented by formula (2-1) include the following:

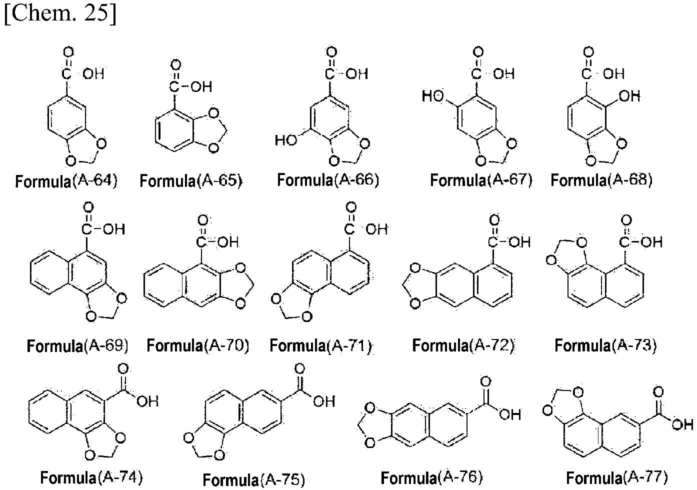

Further information regarding the terminal structures described in WO 2020/071361 is incorporated herein by reference.

(1-3-10)
An end of the polymer chain used in the resist underlayer film-forming composition according to one embodiment of the present invention may have a structure represented by the following formula (41) or (42). By virtue of the polymer being terminated with such a structure, the resist underlayer film is more unlikely to be intermixed with a resist film formed thereon. 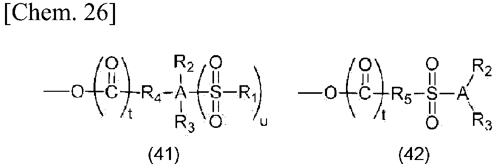 [In formula (41) and formula (42), R₁ denotes an optionally substituted C1-C6 alkyl group, a phenyl group, a pyridyl group, a halogeno group, or a hydroxy group; R₂ denotes a hydrogen atom, a C1-C6 alkyl group, a hydroxy group, a halogeno group, or an ester group represented by -C(=O)O-X, where X denotes an optionally substituted C1-C6 alkyl group; R₃ denotes a hydrogen atom, a C1-C6 alkyl group, a hydroxy group, or a halogeno group; R₄ denotes a direct bond or a C1-C8 divalent organic group; R₅ denotes a C1-C8 divalent organic group; A denotes an aromatic ring or an aromatic heterocyclic ring; t indicates 0 or 1; and u indicates 1 or 2.]

Detailed information regarding the above formulas (41) and (42) is disclosed in WO 2015/163195, which is incorporated herein by reference.

For example, the compounds having a partial structure represented by formula (41) or (42) are compounds represented by the following formula (41a) and/or compounds represented by the following formula (42a). Such compounds can form a new polymer end by bonding to a polymer end that has such a functional group as, for example, a hydroxy group or an amino group, that is capable of forming a chemical bond with the carboxyl group. 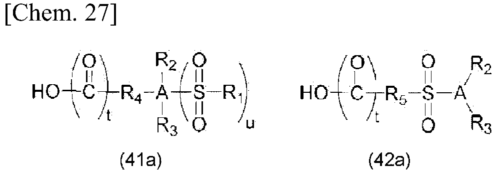 [The symbols in formulas (41a) and (42a) are the same as defined in formulas (41) and (42).]

(1-3-10-1)
Examples of the compounds represented by formula (41a) include compounds represented by the following formulas:

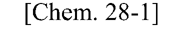

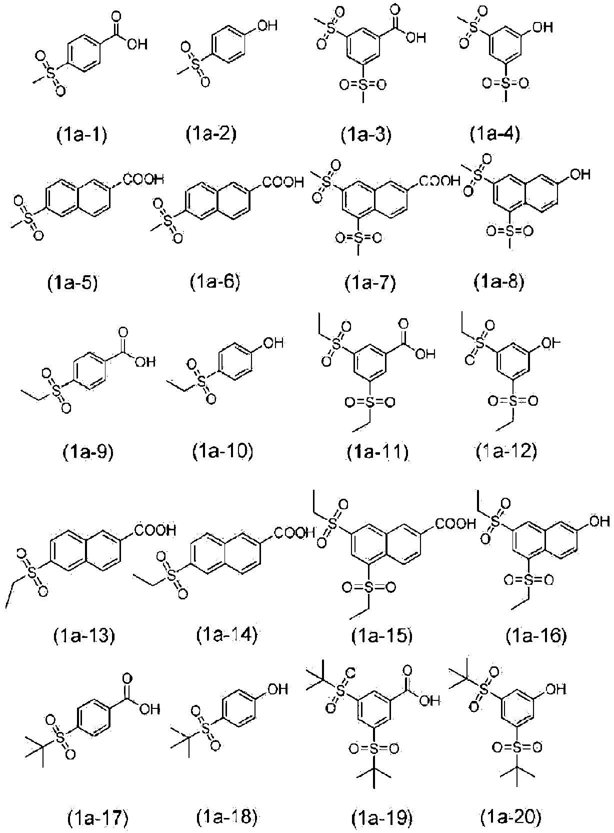

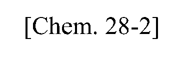

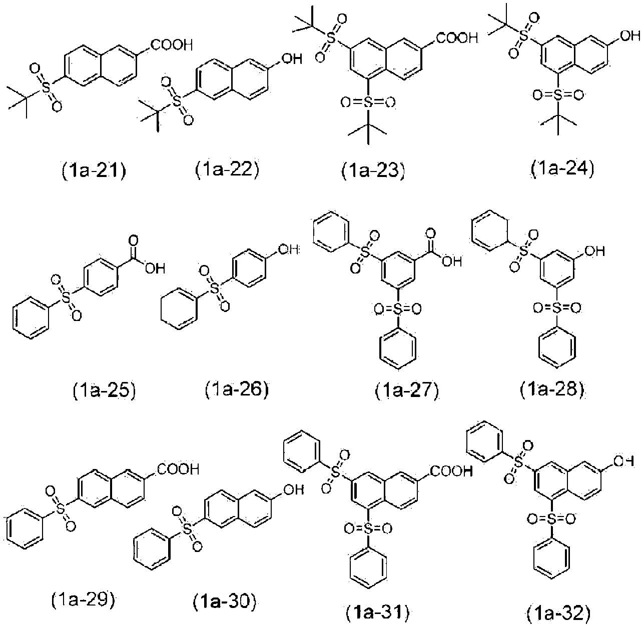

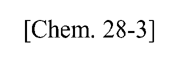

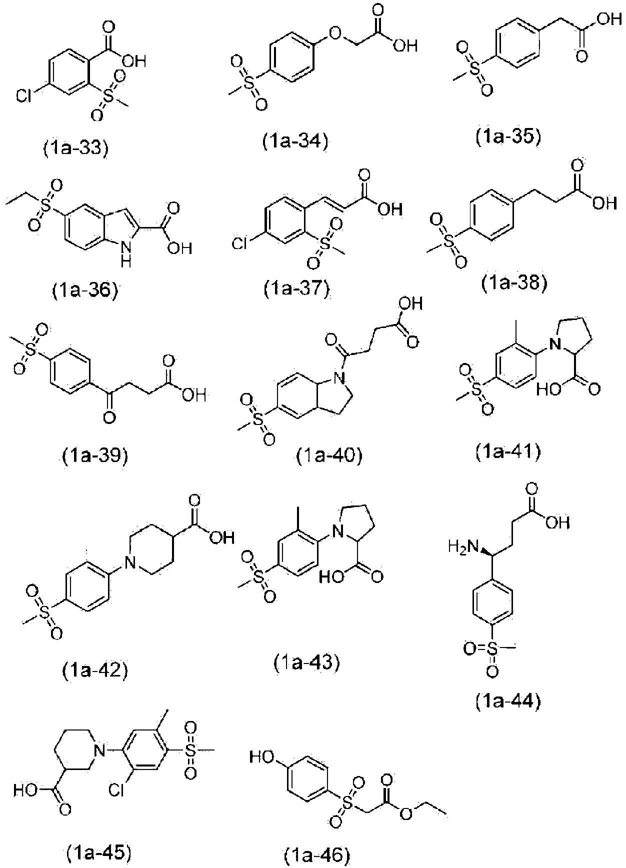

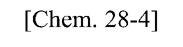

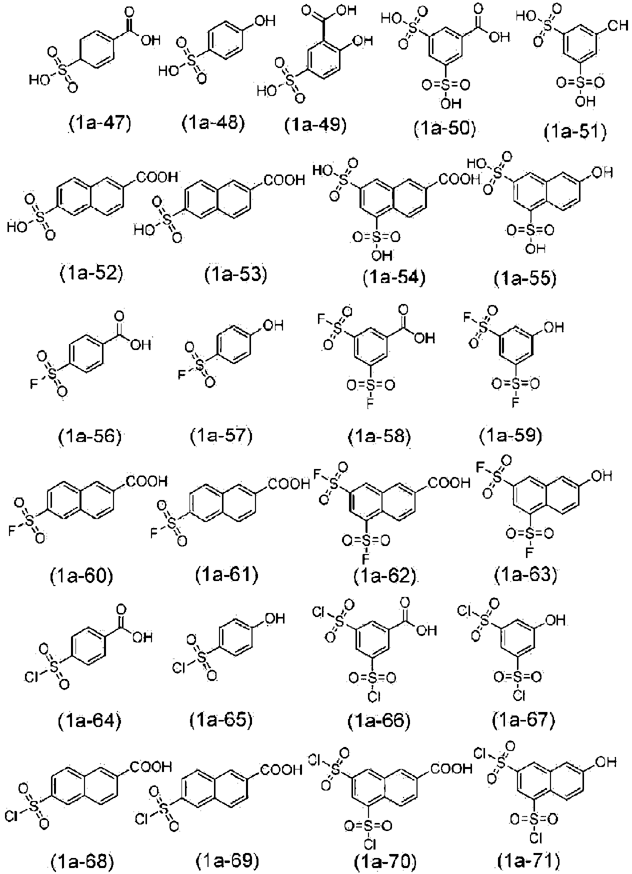

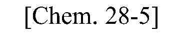

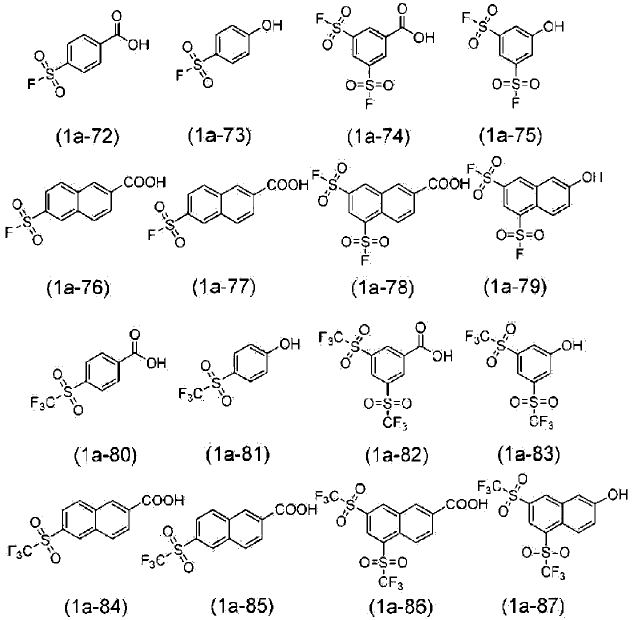

(1-3-10-2)
Examples of the compounds represented by formula (42a) include compounds represented by the following formulas:

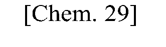

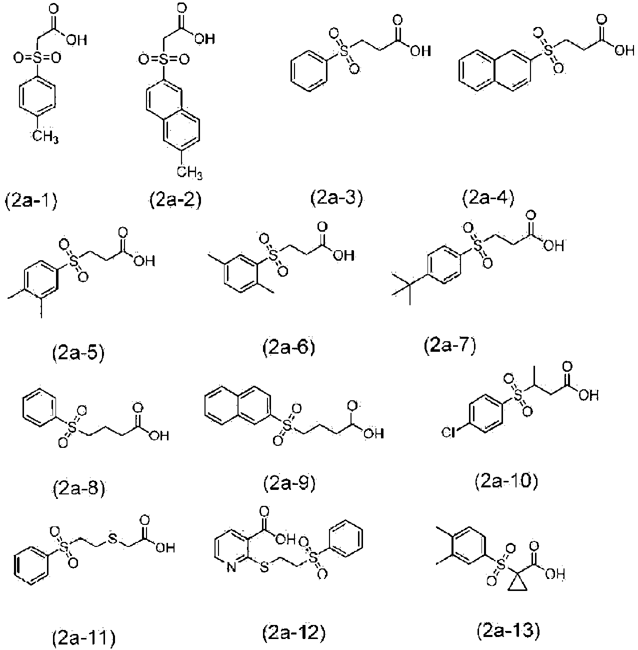

(1-3) Crosslinkers (C)
(1-3-1)
Typical examples of the crosslinkers include aminoplast crosslinkers and phenoplast crosslinkers.

Highly heat-resistant crosslinkers may be used as the crosslinkers. Compounds that contain a crosslinking substituent having an aromatic ring (for example, a benzene ring or a naphthalene ring) in the molecule may be preferably used as the highly heat-resistant crosslinkers.

(I-3-2)
(1-3-2-1)

Exemplary aminoplast crosslinkers include highly alkylated, alkoxylated, alkoxyalkylated, or hydroxyalkylated melamines, benzoguanamines, glycolurils, ureas, and thioureas, and polymers thereof. The crosslinkers have at least two (2), preferably four (4) or more, crosslinking substituents.

Specific examples include the following compounds:
Methoxymethylated glycoluril [= 1,3,4,6-tetrakis(methoxymethyl)glycoluril, tetramethoxymethyl glycoluril, POWDERLINK (registered trademark) 1174)]
Butoxymethylated glycoluril [= 1,3,4,6-tetrakis(butoxymethyl)glycoluril]
Methoxymethylated melamine (= hexamethoxymethyl melamine)
Butoxymethylated melamine
Methoxymethylated benzoguanamine (= tetramethoxymethyl benzoguanamine)
Butoxymethylated benzoguanamine
Methoxymethylated urea (= 1,1,3,3-tetrakis(methoxymethyl)urea)
Butoxymethylated urea (= 1,1,3,3-tetrakis(butoxymethyl)urea)
1,3-Bis(hydroxymethyl)urea
Methoxymethylated thiourea
Methoxymethylated thiourea

(1-3-2-2)
The aminoplast crosslinkers may have, in the molecule thereof, 2 to 6 alkoxyalkyl substituents of formula (51) below, which are described in WO 2017/187969. 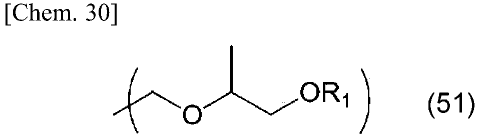 (In formula (51), R₁ denotes a methyl group or an ethyl group.)

The nitrogen-containing compounds that have, in the molecule thereof, 2 to 6 substituents represented by formula (51) may be glycoluril derivatives represented by the following formula (1A): 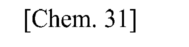 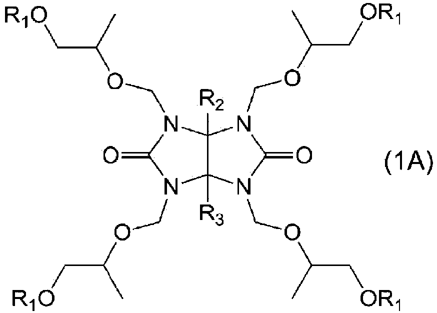 [in formula (1A), four R₁s each independently denote a methyl group or an ethyl group; and R₂ and R₃ each independently denote a hydrogen atom, a C1-C4 alkyl group, or a phenyl group].

Examples of the glycoluril derivatives represented by formula (1A) include compounds represented by the following formulas (1A-1) to (1A-6). 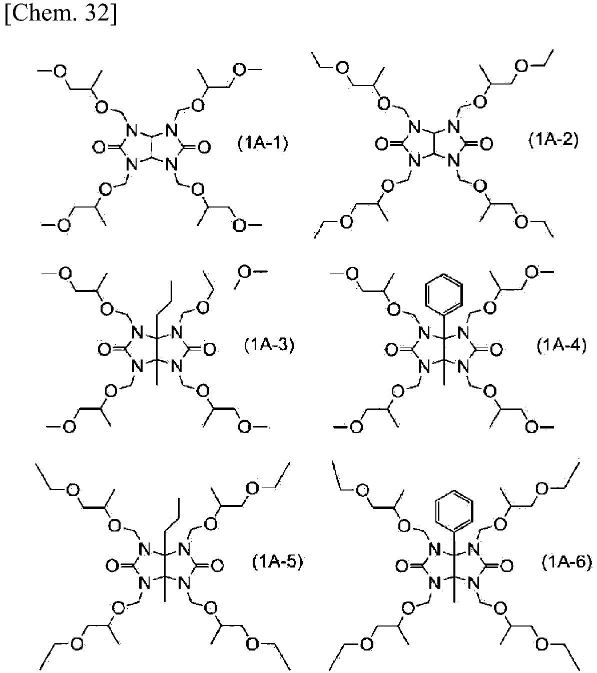 The compounds represented by formula (1A) may be obtained by reacting a nitrogen-containing compound that has, in the molecule thereof, 2 to 6 substituents of formula (52) below bonded to a nitrogen atom, with at least one compound represented by formula (53) below to produce a nitrogen-containing compound having, in the molecule thereof, 2 to 6 substituents represented by formula (51). 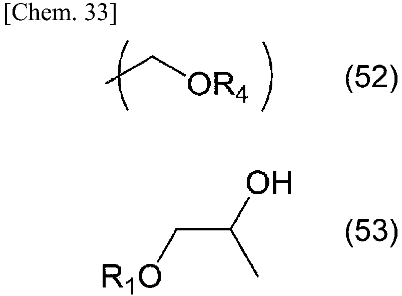 [In formula (52) and formula (53), R₁ denotes a methyl group or an ethyl group; and R₄ denotes a C1-C4 alkyl group.]

The glycoluril derivatives represented by formula (1A) may be obtained by reacting a glycoluril derivative represented by the following formula (2A) with at least one compound represented by formula (53).

For example, the nitrogen-containing compound having, in the molecule thereof, 2 to 6 substituents represented by formula (52) is a glycoluril derivative represented by the following formula (2A): 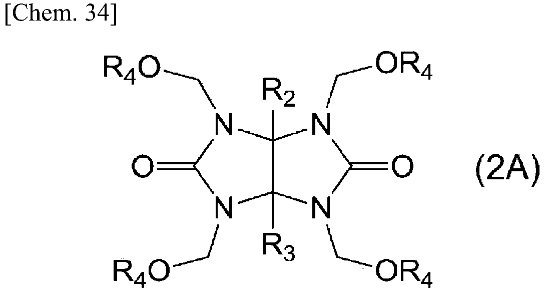 [in formula (2A), R₂ and R₃ each independently denote a hydrogen atom, a C1-C4 alkyl group, or a phenyl group; and R₄ independently at each occurrence denotes a C1-C4 alkyl group].

Examples of the glycoluril derivatives represented by formula (2A) include compounds represented by the following formulas (2A-1) to (2A-4):

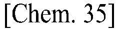

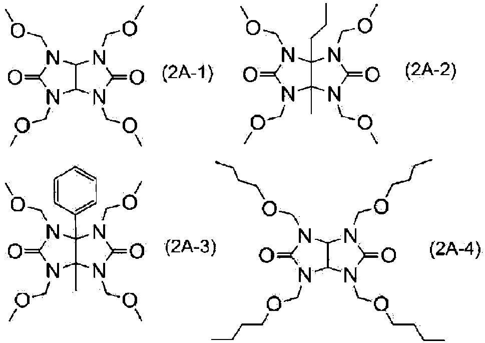

Examples of the compounds represented by formula (53) include compounds represented by the following formulas (3-1) and (3-2):

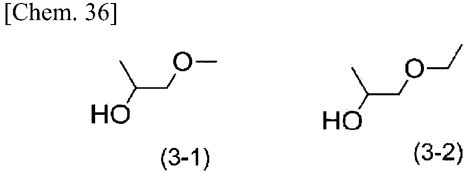

Further details of the nitrogen-containing compounds having, in the molecule thereof, 2 to 6 substituents of formula (51) below bonded to a nitrogen atom are described in WO 2017/187969, which is incorporated herein by reference.

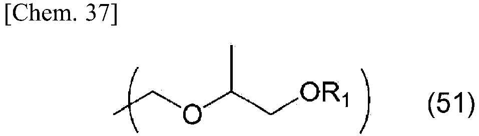

(1-3-3)
(1-3-3-1)
Exemplary phenoplast crosslinkers include highly alkylated, alkoxylated, or alkoxyalkylated aromatics, and polymers thereof. Preferably, the crosslinkers have at least two crosslinking substituents in the molecule, with examples including 2,6-dihydroxymethyl-4-methylphenol, 2,4-dihydroxymethyl-6-methylphenol, bis(2-hydroxy-3-hydroxymethyl-5-methylphenyl)methane, bis(4-hydroxy-3-hydroxymethyl-5-methylphenyl)methane, 2,2-bis(4-hydroxy-3,5-dihydroxymethylphenyl)propane, bis(3-formyl-4-hydroxyphenyl)methane, bis(4-hydroxy-2,5-dimethylphenyl)formylmethane, and α,α-bis(4-hydroxy-2,5-dimethylphenyl)-4-formyltoluene. Condensates of these compounds may also be used.

(1-3-3-2)
Examples of such compounds, in addition to those mentioned above, include compounds that have a partial structure of formula (4) below, and polymers or oligomers that have a repeating unit of formula (5) below. 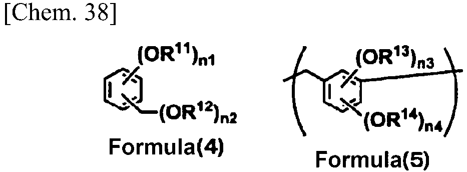 R¹¹, R¹², R¹³, and R¹⁴ are each a hydrogen atom or a C1-C10 alkyl group. Examples of the alkyl groups include those mentioned hereinabove. n1 is an integer of 1 to 4, n2 is an integer of 1 to (5 - n1), and (n1 + n2) is an integer of 2 to 5. n3 is an integer of 1 to 4, n4 is 0 to (4 - n3), and (n3 + n4) is an integer of 1 to 4. The number of the repeating unit structures in the oligomers and the polymers may be within the range of 2 to 100, or 2 to 50.

(1-3-3-3)
Some specific examples are illustrated below:

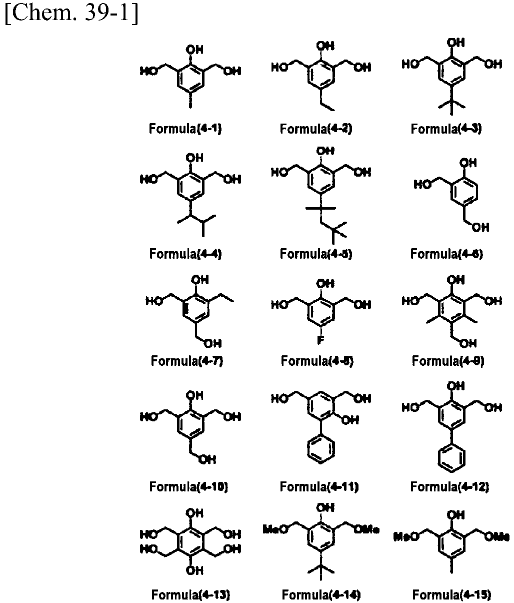

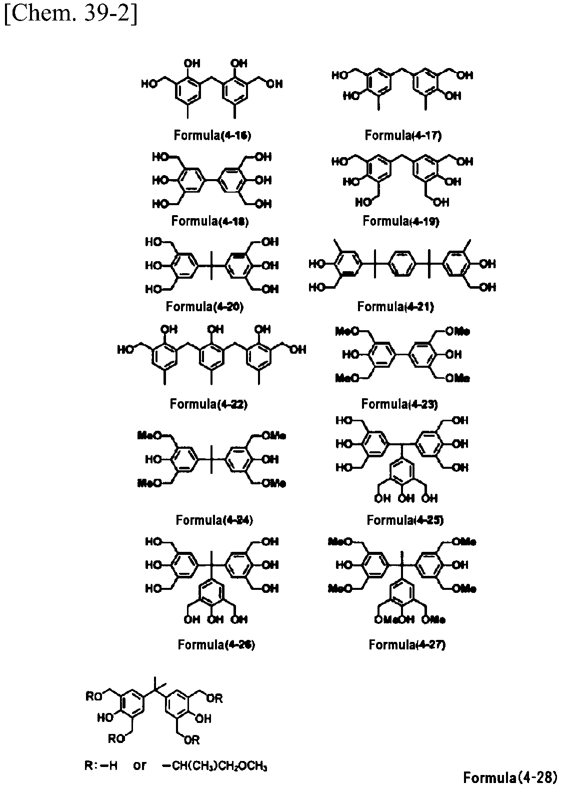

(1-3-3)
The crosslinkers, such as the aminoplast crosslinkers and the phenoplast crosslinkers, may be used each alone or in combination of two or more thereof. The aminoplast crosslinkers may be produced by a method known per se or deemed as known or may be purchased from the market.

The amount in which the crosslinker, such as the aminoplast crosslinker or the phenoplast crosslinker, is used varies depending on factors, such as the coating solvent that is used, the base substrate that is used, the solution viscosity that is required, and the film shape that is required. The content of the crosslinker is, for example, within the range of 1% by mass to 50% by mass, and preferably 5% by mass to 30% by mass of the solid content in the resist underlayer film-forming composition.

(1-4) Curing catalysts (D)
(1-4-1)
The curing catalyst added in the resist underlayer film-forming composition may be an acid or an acid generator, and is preferably an acid generator.

The acid generator may be any thermal acid generator or photoacid generator, and is preferably a thermal acid generator.

(1-4-2)
Examples of the thermal acid generators include 2,4,4,6-tetrabromocyclohexadienone, benzoin tosylate, 2-nitrobenzyl tosylate, K-PURE [registered trademark] series CXC-1612, CXC-1614, TAG-2172, TAG-2179, TAG-2678, TAG2689, and TAG2700 (manufactured by King Industries), SI-45, SI-60, SI-80, SI-100, SI-110, and SI-150 (manufactured by SANSHIN CHEMICAL INDUSTRY CO., LTD.), organic sulfonic acid alkyl esters, such as methyl 4-phenolsulfonate; and sulfonate salts, such as pyridinium-p-toluenesulfonate and pyridinium-p-hydroxybenzenesulfonate.

(1-4-3)
Examples of the photoacid generators include onium salt compounds, sulfonimide compounds, and disulfonyldiazomethane compounds.

Examples of the onium salt compounds include iodonium salt compounds, such as diphenyliodonium hexafluorophosphate, diphenyliodonium trifluoromethanesulfonate, diphenyliodonium nonafluoro- n-butanesulfonate, diphenyliodonium perfluoro-n-octanesulfonate, diphenyliodonium camphorsulfonate, bis(4-tert-butylphenyl)iodonium camphorsulfonate, and bis(4-tert-butylphenyl)iodonium trifluoromethanesulfonate; and sulfonium salt compounds, such as triphenylsulfonium hexafluoroantimonate, triphenylsulfonium nonafluoro-n-butanesulfonate, triphenylsulfonium camphorsulfonate, and triphenylsulfonium trifluoromethanesulfonate.

Examples of the sulfonimide compounds include N-(trifluoromethanesulfonyloxy)succinimide, N-(nonafluoro-n-butanesulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

(1-4-4)
The curing catalysts may be used each alone or in combination of two or more thereof.

For example, the content of the curing catalyst is within the range of 0.1 to 50 parts by mass, and preferably 1 to 30 parts by mass based on the solid content in the resist underlayer film-forming composition.

### (1-5) Solvents (E)

Examples of the organic solvents added to the resist underlayer film-forming compositions of the present invention include alkylene glycol monoalkyl ethers and monocarboxylates thereof, such as ethylene glycol monomethyl ether, ethylene glycol monoethyl ether, diethylene glycol monomethyl ether, diethylene glycol monoethyl ether, propylene glycol monomethyl ether, propylene glycol monoethyl ether, methyl cellosolve acetate, ethyl cellosolve acetate, propylene glycol monomethyl ether acetate, and propylene glycol propyl ether acetate; propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide. These solvents may be used each alone or in combination of two or more thereof.

Of the above solvents, for example, alkylene glycol monoalkyl ethers and monocarboxylates thereof, such as propylene glycol monomethyl ether and propylene glycol monomethyl ether acetate; ethyl lactate, butyl lactate, and cyclohexanone are preferable.

In particular, alkylene glycol monoalkyl ethers and monocarboxylates thereof are preferable, and propylene glycol monomethyl ether and propylene glycol monomethyl ether acetate are more preferable.

(1-6) Additional components
(1-6-1)
To eliminate the occurrence of defects, such as pinholes or striation, and to further enhance the applicability to surface unevenness, the resist underlayer film-forming composition according to one embodiment of the present invention may further include a surfactant.

Examples of the surfactants include nonionic surfactants, such as polyoxyethylene alkyl ethers including polyoxyethylene lauryl ether, polyoxyethylene stearyl ether, polyoxyethylene cetyl ether, and polyoxyethylene oleyl ether, polyoxyethylene alkylaryl ethers including polyoxyethylene octylphenol ether and polyoxyethylene nonylphenol ether, polyoxyethylene/polyoxypropylene block copolymers, sorbitan fatty acid esters including sorbitan monolaurate, sorbitan monopalmitate, sorbitan monostearate, sorbitan monooleate, sorbitan trioleate, and sorbitan tristearate, and polyoxyethylene sorbitan fatty acid esters including polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorosurfactants, such as EFTOP series EF301, EF303, and EF352 (product names, manufactured by Tohkem Products Corp.), MEGAFACE series F171, F173, and R-30 (product names, manufactured by DIC CORPORATION), Fluorad series FC430 and FC431 (product names, manufactured by Sumitomo 3M Limited), AsahiGuard AG710, and Surflon series S-382, SC101, SC102, SC103, SC104, SC105, and SC106 (product names, manufactured by AGC Inc.); and organosiloxane polymer KP341 (manufactured by Shin-Etsu Chemical Co., Ltd.). The amount of the surfactant is usually 2.0% by mass or less, and preferably 1.0% by mass or less of the total solid content in the resist underlayer film-forming composition of the present invention. The surfactants may be added each alone or in combination of two or more thereof.

(1-6-2)
The solid content (the content of film-forming components) in the resist underlayer film-forming composition used in the present invention is, for example, within the range of 0.01 to 50% by mass, 0.05 to 10% by mass, or 0.1 to 5% by mass. Here, the solid content is the content of all the components of the resist underlayer film-forming composition except the solvents.

(1-6-3)
In EB or EUV lithography, the resist underlayer film-forming composition according to one embodiment of the present invention is preferably used to form an EB or EUV lithographic resist underlayer film having a film thickness of 10 nm or less.

[2] Resist underlayer film and laminate (2-1)
A resist underlayer film according to one embodiment of the present invention is a cured product of a coating film including the resist underlayer film-forming composition described above, and may be produced by applying the resist underlayer film-forming composition onto a substrate, such as a semiconductor substrate, and baking the composition. In particular, the resist underlayer film is suitably used as an EB or EUV lithographic resist underlayer film.

A laminate including the substrate and the resist underlayer film also represents an embodiment of the present invention.

Examples of the substrate to which the resist underlayer film-forming composition according to one embodiment of the present invention is applied include semiconductor substrates. Examples of the semiconductor substrates include silicon wafers, germanium wafers, and compound semiconductor wafers, such as gallium arsenide, indium phosphide, gallium nitride, indium nitride, and aluminum nitride.

The semiconductor substrate that is used may have an inorganic film on its surface. For example, such an inorganic film is formed by ALD (atomic layer deposition), CVD (chemical vapor deposition), reactive sputtering, ion plating, vacuum deposition, or spin coating (spin on glass: SOG). Examples of the inorganic films include polysilicon films, silicon oxide films, silicon nitride films, BPSG (boro-phospho silicate glass) films, titanium nitride films, titanium oxynitride films, tungsten films, gallium nitride films, and gallium arsenide films.

The resist underlayer film-forming composition according to one embodiment of the present invention is applied onto such a semiconductor substrate with an appropriate applicator, such as a spinner or a coater. Subsequently, the composition is baked with a heating device, such as a hot plate, to form a resist underlayer film. The baking conditions are appropriately selected from baking temperatures of 100°C to 400°C and amounts of baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the resist underlayer film that is formed is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (1 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), or 0.005 µm (5 nm) to 0.02 µm (20 nm). If the baking temperature is lower than the range mentioned above, crosslinking is insufficient. If, on the other hand, the baking temperature is higher than the above range, the resist underlayer film may be decomposed by heat.

(2-2)
The resist underlayer film-forming composition according to one embodiment of the present invention includes the phenolic antioxidant (A). During post-coating baking in the presence of an acid derived from the curing catalyst, the polymer and the phenolic antioxidant (A) are chemically bonded to each other through the crosslinker to form a cured film. Here, the phenolic antioxidant (A) is lipophilic due to the presence of such substituents as alkyl groups or halogeno groups, and increases its tendency to migrate to the film surface during the formation of a cured film. As a result, the resist underlayer film that is obtained will have structures of the phenolic antioxidant (A) on its surface. Although not bound by theory, the above mechanism is probably the reason that provides enhanced antioxidant properties on the resist underlayer film and reduces the deterioration in LWR (line width roughness, variation (roughness)) in line width) due to diffusion of the composition at the time of resist pattern formation.

Whether or not the phenolic antioxidant is present on the surface of the resist underlayer film may be estimated by measuring the contact angle of the surface of the resist underlayer film with water. The contact angle to water is preferably 55° or more, and more preferably 57° or more.

[3] Method for manufacturing a semiconductor device (3-1)
A method for manufacturing a semiconductor device according to one embodiment of the present invention comprises:
forming on a semiconductor substrate a resist underlayer film comprising a cured product of a coating film comprising the resist underlayer film-forming composition according to the embodiment of the present invention described above; and
forming a resist film on the resist underlayer film.

A method for manufacturing a semiconductor device according to one embodiment of the present invention further comprises:
photoexposing the resist film;
developing the photoexposed resist film, to form a resist pattern; and
forming a patterned resist underlayer film by etching the resist underlayer film through the resist pattern.

(3-2)
The step of forming on a semiconductor substrate a resist underlayer film comprising a cured product of a coating film comprising the resist underlayer film-forming composition is as described in (2-1) hereinabove.

(3-3)
The step of forming a resist film on the resist underlayer film is performed by application and baking according to a method known per se. The photoresist that is formed is not particularly limited as long as the photoresist is sensitive to a light or electron beam used for the photoexposure.

Any of negative photoresists and positive photoresists may be used, such as positive photoresists composed of a novolak resin and 1,2-naphthoquinonediazide sulfonic acid ester; chemically amplified photoresists composed of a photoacid generator and a binder having a group that is decomposed by an acid to increase the alkali dissolution rate; chemically amplified photoresists composed of an alkali-soluble binder, a photoacid generator, and a low-molecular compound that is decomposed by an acid to increase the alkali dissolution rate of the photoresist; chemically amplified photoresists composed of a photoacid generator, a binder having a group that is decomposed by an acid to increase the alkali dissolution rate, and a low-molecular compound that is decomposed by an acid to increase the alkali dissolution rate of the photoresist; and resists containing metal elements.

Examples include V146G, product name, manufactured by JSR CORPORATION, APEX-E, product name, manufactured by Shipley, PAR710, product name, manufactured by Sumitomo Chemical Co., Ltd., and AR2772 and SEPR430, product names, manufactured by Shin-Etsu Chemical Co., Ltd. Examples further include fluorine-containing polymer photoresists, such as those described in Proc. SPIE, Vol. 3999, 330-334 (2000), Proc. SPIE, Vol. 3999, 357-364 (2000), and Proc. SPIE, Vol. 3999, 365-374 (2000).

Furthermore, the so-called resist compositions and metal-containing resist compositions such as resist compositions, radiation-sensitive resin compositions, and high-resolution patterning compositions based on organic metal solutions described, for example, in WO 2019/188595 A1, WO 2019/187881 A1, WO 2019/187803 A1, WO 2019/167737 A1, WO 2019/167725 A1, WO 2019/187445 A1, WO 2019/167419 A1, WO 2019/123842 A1, WO 2019/054282 A1, WO 2019/058945 A1, WO 2019/058890 A1, WO 2019/039290 A1, WO 2019/044259 A1, WO 2019/044231 A1, WO 2019/026549 A1, WO 2018/193954 A1, WO 2019/172054 A1, WO 2019/021975 A1, WO 2018/230334 A1, WO 2018/194123 A1, JP 2018-180525 A, WO 2018/190088 A1, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO 2018/031896 A1, JP 2019-113855 A, WO 2017/156388 A1, WO 2017/066319 A1, JP 2018-41099 A, WO 2016/065120 A1, WO 2015/026482 A1, JP 2016-29498 A, and JP 2011-253185 A may be used, but they are not limited thereto.

(3-4)
A method for forming a pattern according to one embodiment of the present invention comprises at least the following steps:

·A step of forming on a semiconductor substrate a resist underlayer film using the resist underlayer film-forming composition according to one embodiment of the present invention.
·A step of forming on the resist underlayer film a resist film using a resist, preferably an EB or EUV lithographic resist.
·A step of photoexposing the resist film, namely, applying a light or electron beam (preferably EB or EUV) to the resist film, and developing the resist film to form a resist pattern.
·A step of etching the resist underlayer film using the resist pattern as a mask.

(3-5)
An alkaline developer is used in the step of developing the photoexposed resist film into a resist pattern. The conditions are appropriately selected from development temperatures of 5°C to 50°C and amounts of development time of 10 seconds to 300 seconds. Examples of the alkaline developers that may be used include aqueous solutions of alkalis, such as inorganic alkalis including sodium hydroxide, potassium hydroxide, sodium carbonate, sodium silicate, sodium metasilicate, and aqueous ammonia, primary amines including ethylamine and n-propylamine, secondary amines including diethylamine and di-n-butylamine, tertiary amines including triethylamine and methyldiethylamine, alcohol amines including dimethylethanolamine and triethanolamine, quaternary ammonium salts including tetramethylammonium hydroxide, tetraethylammonium hydroxide, and choline, and cyclic amines including pyrrole and piperidine. Appropriate amounts of alcohols, such as isopropyl alcohol, and surfactants, such as nonionic surfactants, may be added to the aqueous alkali solutions mentioned above. Of the developers mentioned above, quaternary ammonium salts are preferable, and tetramethylammonium hydroxide and choline are more preferable. Additional components, such as surfactants, may be added to these developers. An organic solvent, such as butyl acetate, may be used in place of the alkali developer to develop the portions of the photoresist that remain low in alkali dissolution rate. A substrate having a pattern of the resist may be produced through the steps described above.

(3-5)
In the step of etching the resist underlayer film through the resist pattern to form a patterned resist underlayer film, the resist underlayer film is etched using the resist pattern as a mask.

When an inorganic film is present on the surface of the semiconductor substrate that is used, the etching process exposes the surface of the inorganic film. When there is no inorganic film on the surface of the semiconductor substrate that is used, the etching process exposes the surface of the semiconductor substrate. The substrate is then processed by a method known per se (such as a dry etching method). A semiconductor device may be thus manufactured.

### EXAMPLES

The weight average molecular weight of the polymer described in Synthesis Example 1 in the present specification is the result of the measurement by gel permeation chromatography (hereinafter, abbreviated as GPC). The measurement was performed using a GPC device manufactured by TOSOH CORPORATION under the following measurement conditions.

GPC columns: Shodex KF803L, Shodex KF802, and Shodex KF801 [registered trademark] (SHOWA DENKO K.K.)
Column temperature: 40°C
Solvent: N,N-dimethylformamide (DMF)
Flow rate: 0.6 ml/min
Standard samples: polystyrenes (manufactured by TOSOH CORPORATION)

### <Synthesis Example 1>

8.00 g of monoallyldiglycidylisocyanuric acid (manufactured by SHIKOKU KASEI HOLDINGS CORPORATION), 5.45 g of diethylbarbituric acid (manufactured by Tokyo Chemical Industry Co., Ltd.), and 0.48 g of tetrabutylphosphonium bromide (manufactured by Tokyo Chemical Industry Co., Ltd.) were added and dissolved into 56.00 g of propylene glycol monomethyl ether. The reaction vessel was purged with nitrogen and the reaction was performed while performing heating under reflux for 10 hours to give a polymer solution. The polymer solution did not cause any clouding or the like, even after having been cooled to room temperature, and showed good solubility in propylene glycol monomethyl ether. GPC analysis showed that the polymer in the solution obtained had a weight average molecular weight of 10,000 relative to standard polystyrenes. The polymer obtained in this synthesis example has structural units represented by the following formulas (1a) and (1b):

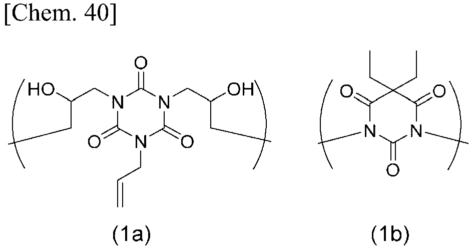

### <Example 1>

0.04 g of tetramethoxymethyl glycoluril (manufactured by Nihon Cytec Industries Co., Ltd.), 0.004 g of p-phenolsulfonic acid pyridinium salt (1:1), and 0.007 g of tris-1,1,3-(2-methyl-4-hydroxy-5-tert-butylphenyl)butane (1c) [ADK STAB (registered trademark) AO-30 (manufactured by ADEKA CORPORATION] were mixed together with 0.33 g of the polymer solution obtained in Synthesis Example 1. 27.20 g of propylene glycol monomethyl ether and 11.98 g of propylene glycol monomethyl ether acetate were added and dissolved. Subsequently, the mixture was filtered through a 0.05 µm polyethylene microfilter to give a lithographic resist underlayer film-forming composition.

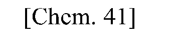

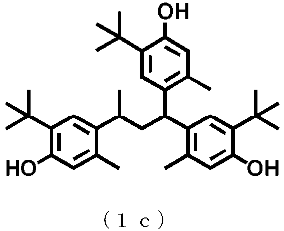

### <Example 2>

0.03 g of tetramethoxymethyl glycoluril (manufactured by Nihon Cytec Industries Co., Ltd.), 0.003 g of p-phenolsulfonic acid pyridinium salt (1:1), and 0.02 g of tris-1,1,3-(2-methyl-4-hydroxy-5-tert-butylphenyl)butane (1c) [ADK STAB (registered trademark) AO-30 (manufactured by ADEKA CORPORATION] were mixed together with 0.31 g of the polymer solution obtained in Synthesis Example 1. 27.16 g of propylene glycol monomethyl ether and 11.98 g of propylene glycol monomethyl ether acetate were added and dissolved. Subsequently, the mixture was filtered through a 0.05 µm polyethylene microfilter to give a lithographic resist underlayer film-forming composition.

### <Comparative Example 1>

0.01 g of tetramethoxymethyl glycoluril (manufactured by Nihon Cytec Industries Co., Ltd.) and 0.001 g of p-phenolsulfonic acid pyridinium salt were mixed (1:1) together with 0.34 g of the polymer solution obtained in Synthesis Example 1. 27.24 g of propylene glycol monomethyl ether and 11.98 g of propylene glycol monomethyl ether acetate were added and dissolved. Subsequently, the mixture was filtered through a 0.05 µm polyethylene microfilter to give a lithographic resist underlayer film-forming composition.

### [Test of dissolution into photoresist solvents]

The resist underlayer film-forming compositions of Example 1, Example 2, and Comparative Example 1 were each applied onto a silicon wafer semiconductor substrate using a spinner. The silicon wafers were set on a hot plate and the coatings were baked at 205°C for 1 minute to form resist underlayer films (film thickness: 5 nm). These resist underlayer films were soaked in photoresist solvents, specifically, ethyl lactate and propylene glycol monomethyl ether. The resist underlayer films were insoluble in these solvents.

### [Measurement of contact angle]

The resist underlayer film-forming compositions of Example 1, Example 2, and Comparative Example 1 were each applied onto a silicon wafer semiconductor substrate using a spinner. The silicon wafers were set on a hot plate and the coatings were baked at 205°C for 1 minute to form resist underlayer films (film thickness: 5 nm). Pure water was dropped onto the resist underlayer films, and the contact angle with pure water was measured with a contact angle meter (device name: DM-701 (manufactured by Kyowa Interface Science Co., Ltd.)). Table 1 shows the results. The results demonstrate that, attributable to increased amount of the additive, the hydrophobicity in Example 1 and Example 2 was higher than Comparative Example 1, and the additive (the compound represented by formula (1c)) remained in the film even after baking.

### [Table 1]

**Table 1**

| | Contact angle to water |
|---|---|
| Example 1 | 57° |
| Example 2 | 63° |
| Comparative Example 1 | 54° |

### [Formation of positive resist pattern with electron beam lithography system]

The resist underlayer film-forming compositions of Example 1, Example 2, and Comparative Example 1 were each applied onto a silicon wafer using a spinner. The silicon wafers were baked on a hot plate at 205°C for 60 seconds to form resist underlayer films having a film thickness of 5 nm. Each of the resist underlayer films was spin-coated with an EUV positive resist solution (containing a methacrylic polymer), and the coating was heated at 130°C for 60 seconds to form an EUV resist film. The resist film was photoexposed under predetermined conditions using an electron beam lithography system (ELS-G130). After the photoexposure, baking (PEB) was performed at 100°C for 60 seconds. The resist film was then cooled to room temperature on a cooling plate and was developed with an alkaline developer (2.38% TMAH), to subsequently form a resist pattern having 22 nm line pattern/44 nm pitches. The length measurement for the resist pattern was made with a scanning electron microscope (CG4100 manufactured by Hitachi High-Tech Corporation). The thus obtained photoresist pattern was evaluated by observation from above the pattern. Table 2 shows the LWR in the line pattern with a CD size of 22 nm.

### [Table 2]

**Table 2**

| | LWR in the line pattern with a CD size of 22 nm |
|---|---|
| Example 1 | 3.41 nm |
| Example 2 | 3.31 nm |
| Comparative Example 1 | 3.44 nm |

Example 1 and Example 2 effectively improved LWR in the line pattern with a CD size of 22 nm as compared to Comparative Example 1. These results reveal that the resist underlayer film containing the compound represented by formula (1c) enables improvements in LWR and exhibits good patternability.

## Claims

1. A resist underlayer film-forming composition comprising a phenolic antioxidant (A) having seven or more carbon atoms, and containing an aryl ring having a phenolic hydroxy group, wherein at least one of carbon atoms in ortho or para position relative to a carbon atom carrying the phenolic hydroxy group of the aryl ring has a substitutable hydrogen atom; a crosslinker-reactive polymer (B); a crosslinker (C); a curing catalyst (D); and a solvent (E).

2. The resist underlayer film-forming composition according to claim 1, wherein the phenolic antioxidant (A) is at least one member selected from the group consisting of antioxidants represented by formulas (I) to (III) below: 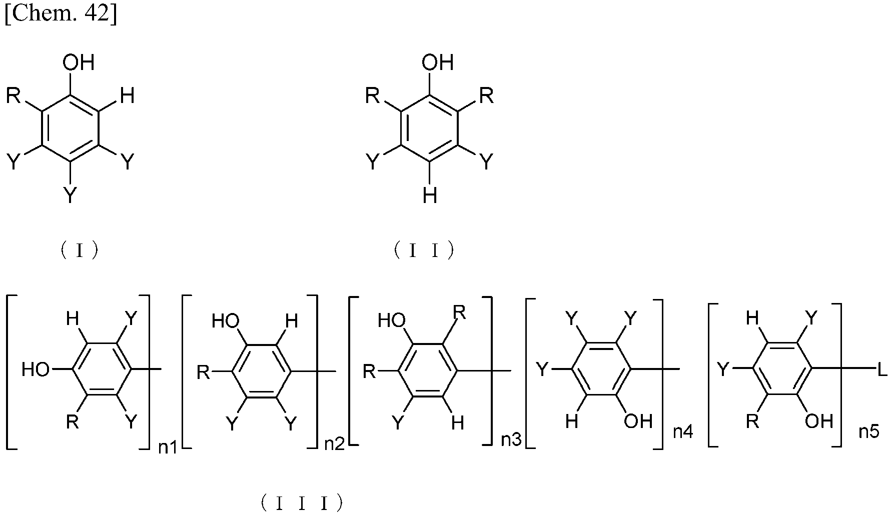 [in formulas (1) to (III),
R independently at each occurrence denotes an optionally substituted C1-C10 alkyl group or a halogeno group,
Y independently at each occurrence denotes a hydrogen atom, a hydroxy group, a C1-C10 alkoxy group, an optionally substituted C1-C10 alkyl group, or a halogeno group; when any R and Y adjacent to each other, or any two Ys adjacent to each other are both optionally substituted alkyl groups, the optionally substituted alkyl groups are optionally bonded to each other to form a ring; when one Y is a hydroxy group, the other Y or Ys on the same benzene ring each denote a hydrogen atom, a C1-C10 alkoxy group, an optionally substituted C1-C10 alkyl group, or a halogeno group,
L denotes a (n1 + n2 + n3 + n4 + n5)-valent linking group that connects the carbon atoms of a (n1 + n2 + n3 + n4 + n5) quantity of benzene rings each constituting a phenol ring; n1, n2, n3, n4, and n5 each indicate an integer of 0 or greater; and the total of n1, n2, n3, n4, and n5 is 2 or greater].

3. The resist underlayer film-forming composition according to claim 2, wherein formula (I) is the following formula (I-1) or (I-2): 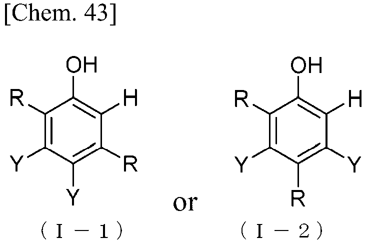 [wherein R and Y in formula (I-1) and formula (I-2) are the same as defined in formula (I)].

4. The resist underlayer film-forming composition according to claim 1, wherein the polymer (B) is a cyanuric acid-based polymer, a polyester-based polymer, or an acrylic-based polymer.

5. The resist underlayer film-forming composition according to claim 1, wherein the crosslinker (C) is at least one member selected from the group consisting of aminoplast crosslinkers and phenoplast crosslinkers.

6. The resist underlayer film-forming composition according to claim 1, wherein the solvent (E) comprises at least one member selected from the group consisting of alkylene glycol monoalkyl ethers and alkylene glycol monoalkyl ether monocarboxylates.

7. A resist underlayer film comprising a cured product of a coating film comprising the resist underlayer film-forming composition according to any one of claims 1 to 6.

8. The resist underlayer film according to claim 7, which has a contact angle to water of 55° or more.

9. A laminate comprising a substrate and the resist underlayer film according to claim 7 or 8.

10. A method for manufacturing a semiconductor device, comprising:
forming on a semiconductor substrate a resist underlayer film, which is a cured product of a coating film comprising the resist underlayer film-forming composition according to any one of claims 1 to 6; and
forming a resist film on the resist underlayer film.

11. A method for manufacturing a semiconductor device, comprising:
forming on a semiconductor substrate a resist underlayer film comprising a cured product of a coating film comprising the resist underlayer film-forming composition according to any one of claims 1 to 6;
forming a resist film on the resist underlayer film;
photoexposing the resist film;
developing the photoexposed resist film, to form a resist pattern; and
forming a patterned resist underlayer film by etching the resist underlayer film through the resist pattern.
